# EUROPÄISCHE PATENTSCHRIFT

(11) **EP 1 070 444 B1**
(45) Veröffentlichungstag und Bekanntmachung des Hinweises auf die Patenterteilung: **17.04.2002**
(21) Anmeldenummer: 99924725.7
(22) Anmeldetag: 25.03.1999
(51) Int. Cl.: H05K 3/10, H01L 21/00

(54) **VERFAHREN UND VORRICHTUNG ZUR HERSTELLUNG VON DÜNNSCHICHTSTRUKTUREN**
METHOD AND DEVICE FOR PRODUCING THIN-LAYER STRUCTURES
PROCEDE ET DISPOSITIF POUR REALISER DES STRUCTURES A COUCHES MINCES

(30) Priorität: 09.04.1998 DE 19817530
(43) Veröffentlichungstag der Anmeldung: 24.01.2001
(73) Patentinhaber: B.R. Deutschland, vertr.d. Bundesministerium f. Wirtschaft u. Technologie, dieses vertr.d. Präs. d. Phys.-Techn. Bundesanstalt, 38116 Braunschweig (DE)
(72) Erfinder: KOCH, Hans, D-12159 Berlin (DE); SEMMLER, Wolfhard, D-13467 Berlin (DE)
(74) Vertreter: Wablat, Wolfgang, Dr.Dr.
(86) Internationale Anmeldenummer: DE9900958
(87) Internationale Veröffentlichungsnummer: WO9953738

(56) Entgegenhaltungen:
- EP-A- 0 417 294
- WO-A-88/09598
- DE-A- 3 047 884
- K. F. TENG ET AL.: "Liquid ink jet printing with MOD inks for hybrid microcircuits" IEEE TRANSACTIONS ON COMPONENTS,HYBRIDS,AND MANUFACTURING TECHNOLOGY., Bd. 12, Nr. 4, Dezember 1987 (1987-12), Seiten 545-549, XP002114337 IEEE INC. NEW YORK., US ISSN: 0148-6411
- PATENT ABSTRACTS OF JAPAN vol. 16, no. 26 (M-1202), 22. Januar 1992 (1992-01-22) & JP 03 239551 A (MATSUSHITA ELECTRIC WORKS), 25. Oktober 1991 (1991-10-25)

## Beschreibung

Die Erfindung betrifft ein Verfahren zur Herstellung von Dünnschichtstrukturen, bei dem auf einem Substrat dünne, geometrisch strukturierte Schichten ein- oder mehrschichtig und gegebenenfalls in variabler Schichtdicke erzeugt werden, sowie eine Vorrichtung zur Durchführung des Verfahrens . Ein derartiges Verfahren ist aus dem Dokument "Liquid ink jet printing with MOD inks for hybrid microcircuits", IEEE Transactions on components, hybrids and manufacturing technology, Bd. 12, Nr. 4, Dezember 1987 bekannt.

Dünnschichtstrukturen werden unter Verwendung unterschiedlicher Materialien für die verschiedensten Anwendungszwecke, z. B. für elektronische Schaltungen, für beschichtete Brillengläser oder Fensterscheiben, für DNA-Chips, für Trockenchemieteststreifen, für mikromechanische Dünnschichtstrukturen und vieles andere, genutzt.

Bei den bekannten Verfahren zur Herstellung von Mehrlagendünnschichtstrukturen, z. B. für elektronische Bauelemente und integrierte Schaltungen, wird in Beschichtungsanlagen ein großflächiger Dünnfilm aus leitendem Material, zum Beispiel aus Kupfer, Silber und dgl., auf ein Substrat aufgebracht. Diese Beschichtung erfolgt im wesentlichen durch Aufdampfen oder unter Anwendung von Sputter-, Epitaxie- bzw. Laserablationsverfahren oder durch elektrochemische Prozesse. Die Strukturierung der Leiterbahnen oder der Bauelementschichten erfolgt mit Hilfe unterschiedlicher Lithographieverfahren. Zu diesem Zweck wird zunächst eine Maske mit der zu erzeugenden Struktur erstellt und über diese eine auf die leitende Schicht des Substrats aufgebrachte strahlungsempfindliche Lackschicht mit UV-Strahlen, Röntgenstrahlen, Elektronenstrahlen oder lonenstrahlen belichtet. Anschließend wird die belichtete bzw. die unbelichtete Lackschicht weggelöst und die freigelegte Oberflächenschicht weggeätzt. Schließlich wird die verbliebene Lackschicht von der verbliebenen, nun beispielsweise einen Leiterstreifen bildenden Oberflächenschicht abgelöst.

Gerade bei der Herstellung komplizierter Schaltkreise, beispielsweise mit einer Mehrzahl sich kreuzender, voneinander isolierter Leiterbahnen, die zudem - auch in ein und derselben Leiterbahn - unterschiedliche Schichtdicken aufweisen und gegebenenfalls auch aus miteinander gemischten Werkstoffen bestehen können, sind die bekannten Lithographieverfahren sehr zeit- und kostenaufwendig, da zum einen eine große Zahl unterschiedlicher Arbeitsschritte erforderlich ist und zum anderen das benötigte Instrumentarium extrem teuer ist.

Der Erfindung liegt daher die Aufgabe zugrunde, ein Verfahren zur Herstellung von vielfältig strukturierten Mehrlagendünnschichtstrukturen der eingangs erwähnten Art anzugeben, bei dem der Arbeits- und Zeitaufwand gegenüber den bekannten Lithographieverfahren deutlich verringert ist und zudem Einsparungen hinsichtlich des Materialbedarfs und der erforderlichen Apparaturen erzielt werden können.

Erfindungsgemäß wird die Aufgabe mit einem Verfahren zur Herstellung von Dünnschichtstrukturen gemäß des Patentanspruchs 1 gelöst.

Der Kern der Erfindung besteht mit anderen Worten in der Anwendung eines dem Tintenstrahldruckerprinzip entsprechenden Verfahrens für das unmittelbare Ausbilden bzw. Auftragen der unterschiedlichen Dünnschichtstrukturen in ihrer konkreten geometrischen Form, und zwar in einzelnen und/oder übereinanderliegenden Schichten. Die Strukturelemente werden mit einem feinsten Strahl bzw. feinsten Tröpfchen aus flüssigem Dünnschichtmaterial gleichsam gedruckt, jedoch mit dem Unterschied zum herkömmlichen Tintenstrahldrucken, daß für Dünnschichtstrukturen geeignete Ausgangsstoffe in verflüssigtem Zustand im Vakuum auch in mehreren Schichten und in unterschiedlicher oder sich in einer Schicht ändernder Schichtdicke auf das Substrat aufgetragen werden.

Gegenüber den bekannten Lithographie- und Dünnschichttechniken ist das erfindungsgemäß vorgeschlagene Verfahren weitaus leistungsfähiger, das heißt, mit verringertem Arbeitsaufwand können komplizierteste Dünnschichtstrukturen materialsparend und in kürzerer Zeit sowie mit verringertem apparativem Aufwand hergestellt werden.

Weitere Merkmale und vorteilhafte Weiterbildungen der Erfindung ergeben sich aus den Unteransprüchen.

Die Erfindung wird am Beispiel der Herstellung einer elektronischen Dünnschichtschaltung aus zwei sich kreuzenden und im Kreuzungsbereich voneinander isolierten Leiterbahnen näher erläutert.

Da die zur Herstellung der Schaltung verwendete Vorrichtung im wesentlichen einem bekannten, an einen Rechner angeschlossenen Tintenstrahldrucker entspricht, wird auf dessen zeichnerische Darstellung im Ausführungsbeispiel verzichtet. Der Unterschied zu dem herkömmlichen Tintenstrahldrucker besteht hier darin, daß die einem Düsenkopf zugeordneten Vorratsbehälter mit Leitsilber bzw. mit Lack als Isoliermaterial gefüllt sind. Beide Stoffe befinden sich aufgrund der Mischung mit einem Lösungsmittel in einemfließfähigen Zustand. Die mit der Leitsilberlösung und dem Flüssiglack in Berührung kommenden Teile der Vorrichtung bestehen aus lösungsmittelbeständigem (oder bei erforderlicher Erwärmung des Materials im Falle des Auftragens in schmelzflüssigem Zustand auch aus hitzebeständigem) Werkstoff. Die Schließmechanismen der an die Vorratsbehälter angeschlossenen und entsprechend dem jeweiligen Werkstoff dimensionierten Materialausgabedüsen des Düsenkopfes (Druckkopfes) der Vorrichtung sowie die Linearbewegung des Düsenkopfes und die dazu senkrechte Bewegung des Substrats werden durch ein in dem Rechner gespeichertes Programm gesteuert. Als Substrat wird z. B. ein Siliziumwafer verwendet, auf die die Leitsilberstreifen sowie die Isolierschichten an deren Überkreuzungen aufgetragen werden. Zunächst wird rechnergesteuert der erste Leiterstreifen auf dem Siliziumwafer erzeugt, indem entsprechend dem gespeicherten Leiterstreifenmuster der Druckkopf bei geöffneter Materialausgabedüse für die Leitsilberlösung in X-Richtung hin- und herbewegt und der Siliziumwafer relativ dazu in Y-Richtung bewegt wird. Dabei wird die Leitsilberlösung im Vakuum entsprechend dem Tintenstrahldruckverfahren in Form feinster Tröpfchen (pixelweise) auf den Siliziumwafer gespritzt, trocknet durch Verdunstung des Lösungsmittels ein und verbleibt als feste, elektrisch leitfähige streifenförmige Dünnschicht auf dem Substrat. Programmgesteuert werden anschließend die vorgegebenen Überkreuzungen vom Druckkopf angefahren und an den betreffenden Stellen die Materialabgabedüsen für den Flüssiglack geöffnet. Der aufgespritzte Flüssiglack trocknet ebenfalls ein und bildet auf dem ersten Leiterstreifen eine fest haftende Isolierschicht. Schließlich wird der zweite Leiterstreifen entsprechend seinem gespeicherten Muster hergestellt. An den Überkreuzungen mit dem ersten Leiterstreifen sind somit drei übereinanderliegende Schichten gebildet, wobei die sich kreuzenden Leiterstreifen durch eine Isolierschicht elektrisch voneinander getrennt sind.

Die Erfindung ist selbstverständlich nicht auf das oben beschriebene, sehr einfache Ausführungsbeispiel beschränkt. Vielmehr ist es möglich, mit dem nach den Grundprinzipien der Tintenstrahldrucktechnik durchgeführten Verfahren komplizierteste Dünnschichtstrukturen mit einer Mehrzahl übereinanderliegender, in der Schichtdicke variierender Schichten aus unterschiedlichen Stoffen, die erst bei höheren Temperaturen fließfähig sind oder die Mischungen aus verschiedenen Stoffen sind, auf das Substrat aufzutragen.

## Patentansprüche

1. Verfahren zur Herstellung von Dünnschichtstrukturen unter Anwendung eines auf dem Prinzip des Tintenstrahldruckers basierenden Schreibwerkes, bei dem auf ein Substrat dünne geometrisch strukturierte Schichten ein- oder mehrschichtig und in gleichbleibender oder variabler Schichtdicke aus mindestens einem Vorratsbehälter mit in diesem befindlichen, durch Temperatureinwirkung oder Lösungsmittel verflüssigten Ausgangsmaterialien mit, Hilfe eines Schreibkopfes hinsichtlich Dosierung und Positionierung rechnergesteuert aufgetragen werden, **dadurch gekennzeichnet, daß** das Auftragen der Ausgangsmaterialien mit dem Schreibwerk auf das Substrat im Vakuum erfolgt.

2. Verfahren nach Anspruch 1, **dadurch gekennzeichnet, daß** zwei oder mehrere Ausgangsmaterialien aus verschiedenen Vorratsbehältern zur Erzeugung von Stoffmischungen gleichzeitig aufgetragen werden, wobei die Zusammensetzung der Stoffmischungen auf der Basis der Bewegungsgeschwindigkeit des Substrats und der Schreibköpfe in Verbindung mit der Dosiermenge geregelt wird.

3. Verfahren nach Anspruch 1 und 2, **dadurch gekennzeichnet, daß** die Dünnschichtstrukturen unter Anwendung mehrerer Düsenköpfe an unterschiedlichen Positionen gleichzeitig auf das Substrat aufgegeben oder übereinandergeschichtet werden.

4. Verfahren nach einem der Ansprüche 1-3, dadurch gekennzeicnet, daß die Erzeugung der dreidimensionalen geometrischen Strukturen auf der Basis der Bewegung des Schreibkopfes und des Substrates in X- bzw. Y-Richtung erfolgt sowie zur Ausbildung der Schichten in Z-Richtung auf der jeweiligen Bewegungsgeschwindigkeit und der Dosiermenge beruht.

5. Verfahren nach einem der Ansprüche 1-4, **dadurch gekennzeichnet, daß** das Auftragen der Ausgangsmaterialien in einer Schutzgasatmosphäre und/oder unter einem bestimmten Temperaturregime erfolgt.

## Claims

1. A method for producing thin-film structures using a recording mechanism based on the operating principle of an inkjet printer where a write head that is computer-controlled regarding its medium dosage and positioning applies one or several thin geometrically structured layers at equal or variable thickness to a substrate from at least one storage tank containing parent substances that are liquefied using heat or solvents, **characterized in that** said recording mechanism applies said parent materials to said substrate in a vacuum.

2. The method according to claim 1, **characterized in that** two or more parent substances are simultaneously applied from different storage tanks to produce mixtures, the composition of said mixtures being controlled by means of substrate and write head velocity and of the metered dose.

3. The method according to claims 1 and 2, **characterized in that** said thin-film structures are simultaneously applied to the substrate at different positions using multiple nozzles, or are superimposed.

4. The method according to any one of claims 1 through 3, **characterized in that** said write head and substrate move in directions X or Y to produce three-dimensional geometric structures, and **in that** said layers are formed in direction Z based on velocity of movement and dosage.

5. The method according to any one of claims 1 through 4, **characterized in that** said parent materials are applied in an inert gas atmosphere and/or subject to a specific temperature control pattern.

## Revendications

1. Procédé pour réaliser des structures à couches minces au moyen d'un mécanisme d'écriture basé sur le principe de l'imprimante à jet d'encre, où de minces couches structurées géométriquement sont appliquées sur un substrat en une ou plusieurs couches et en une épaisseur de couche constante ou variable depuis au moins un réservoir contenant des matières de départ liquéfiées sous l'effet de la température ou d'un solvant au moyen d'une tête d'écriture de manière commandée par ordinateur concernant le dosage et le positionnement, **caractérisé en ce que** l'application sur le substrat des matières de départ avec le mécanisme d'écriture se déroule sous vide.

2. Procédé selon la revendication 1 **caractérisé en ce que** deux ou plusieurs matières de départ sont appliquées simultanément depuis différents réservoirs pour produire des mélanges de substances, où la composition des mélanges de substances est régulée sur la base de la vitesse de déplacement du substrat et des têtes d'écriture en liaison avec la quantité de dosage.

3. Procédé selon les revendications 1 et 2 **caractérisé en ce que** les structures à couches minces sont appliquées simultanément sur le substrat au moyen de plusieurs têtes de buses en des positions différentes ou sont appliquées les unes sur les autres.

4. Procédé selon l'une des revendications 1 à 3 **caractérisé en ce que** la production des structures géométriques tridimensionnelles a lieu sur la base du déplacement de la tête d'écriture et du substrat dans la direction X ou Y et est basée sur la vitesse de déplacement correspondante et la quantité de dosage pour former les couches dans la direction Z.

5. Procédé selon l'une des revendications 1 à 4 **caractérisé en ce que** l'application des matières de départ a lieu dans une atmosphère de gaz protecteur et/ou sous un régime de température déterminé.
